# EUROPÄISCHE PATENTSCHRIFT

(11) **EP 2 368 280 B1**
(45) Veröffentlichungstag und Bekanntmachung des Hinweises auf die Patenterteilung: **02.09.2015**
(21) Anmeldenummer: 09760518.2
(22) Anmeldetag: 24.11.2009
(51) Int. Cl.: H01L 39/24

(54) **VERFAHREN ZUR HERSTELLUNG VON METALLSUBSTRATEN FÜR HTS-SCHICHTANORDNUNGEN**
METHOD FOR PRODUCING METAL SUBSTRATES FOR HTS COATING ARRANGEMENTS
PROCÉDÉ DE FABRICATION DE SUBSTRATS MÉTALLIQUES POUR AGENCEMENTS STRATIFIÉS SUPRACONDUCTEURS À HAUTE TEMPÉRATURE (HTS)

(30) Priorität: 24.11.2008 DE 102008058768
(43) Veröffentlichungstag der Anmeldung: 28.09.2011
(73) Patentinhaber: BASF SE, 67056 Ludwigshafen (DE)
(72) Erfinder: BÄCKER, Michael, 50670 Köln (DE); FALTER, Martina, 53359 Swisstal (DE); KUNERT, Jan, 53359 Rheinbach (DE)
(86) Internationale Anmeldenummer: PCT/EP2009/065766
(87) Internationale Veröffentlichungsnummer: WO 2010/058031

(56) Entgegenhaltungen:
- EP-A- 1 653 484
- WO-A-2008/078852
- US-A1- 2005 016 867
- US-A1- 2005 220 986

## Beschreibung

Die Erfindung betrifft ein Verfahren zur Herstellung eines biaxialen texturierten Metallsubstrats mit einer Metalloberfläche, die zur Herstellung einer Hochtemperatursupraleiter (HTS)-Schichtanordnung angepasst ist, wobei die Metalloberfläche angepasst ist, um auf dieser epitaktisch eine Schicht der HTS-Schichtanordnung wie beispielsweise eine Pufferschicht, eine andere Zwischenschicht und/oder eine HTS-Schicht abzuscheiden. Weiterhin betrifft die Erfindung ein Verfahren zur Herstellung einer HTS-Schichtanordnung, bei welchem eine Pufferschicht und/oder eine andere Zwischenschicht und/oder eine Hochtemperatursupraleiter-Schicht epitaktisch auf dem Metallsubstrat aufgebracht wird.

Bei der Herstellung von Hochemperatursupraleiter (HTS)-Schichtanordnungen werden auf einem biaxial texturierten Metallsubstrat zumeist epitaktisch eine oder mehrere Pufferschichten aufgebracht, auf der/denen epitaktisch eine Hochtemperatursupraleiter (HTS)-Schicht aufgebracht wird. Die Pufferschicht dient hierbei insbesondere als Diffusionsbarriere, um eine Diffusion von Metallatomen oder Verunreinigungen aus dem Metallsubstrat in die HTS-Schicht zu verhindern. Hierzu sind unterschiedliche Abscheidungsverfahren bekannt, beispielsweise eine Gasphasenabscheidung der die Pufferschicht und/oder die HTS-Schicht bildenden Komponenten, beispielsweise als MOCVD, chemische Lösungsbeschichtung, bei welcher die Puffer- und/oder HTS-Schichtmaterialien unter Verwendung von Precursoren abgeschieden werden, oder physikalische Verfahren wie Pulsed-Laser-Deposition (PLD), thermische Coverdampfung (TCE) usw. Insbesondere bei chemischer Lösungsbeschichtung ist ein Texturübertrag von dem Metallsubstrat auf die HTS-Schicht erforderlich, um eine texturierte HTS-Schicht erzeugen zu können. Bei Verwendung einer Pufferschicht ist dementsprechend ein Texturübertrag von dem Metallsubstrat auf die Pufferschicht und von dieser auf die HTS-Schicht erforderlich.

Das Metallsubstrat ist in verschiedener Hinsicht für die Eigenschaften der HTS-Schicht von Bedeutung, insbesondere auch was die Erzielung hoher kritischer Stromdichten und gegebenenfalls auch die Schärfe des supraleitenden Übergangs (ΔT_{c}) betrifft. Die Anforderungen an das Metallsubstrat sind hierbei vielfältig. So soll das Metallsubstrat eine möglichst große chemische Reinheit aufweisen, einen hohen Texturierungsgrad und nach Möglichkeit eine möglichst geringe Oberflächenrauhigkeit, um ein Aufwachsen einer weiteren Schicht der HTS-Schichtanordnung wie z.B. einer Pufferschicht oder einer anderen Zwischenschicht ist zu ermöglichen. Eine möglichst geringe Rauhigkeit der Metalloberfläche ist zumeist erwünscht, um Fehlorientierungen in der aufwachsenden Schicht der HTS-Schichtanordnung zu minimieren.

Entscheidend für die Qualität der auf dem Metallsubstrat abgeschiedenen Schichten, insbesondere auch im Hinblick auf die kritische Stromdichte der HTS-Schicht, ist somit auch die Oberflächen des Metallsubstrats, insbesondere deren Textur und Rauhigkeit.

Andererseits soll das erfindungsgemäße Verfahren die Herstellung möglichst optimaler Aufwachschichten wie z.B. Pufferschichten mit hoher Texturierung auch im industriellen Maßstab ermöglichen. Der Herstellung von Metallsubstraten im industriellen Maßstab sind jedoch insbesondere auch hinsichtlich der Oberflächenqualität Grenzen gesetzt, welche Voraussetzung für einen optimalen Texturübertrag von dem Metallsubstrat auf die Aufwachsschicht ist. So wird in einem industriellen Herstellungsverfahren das biaxial texturierte Metallsubstrat zumeist durch eine Kaltverformung mit einem Verformungsgrad von ≤ 95% und einer nachfolgenden speziellen Glühbehandlung hergestellt. Die Kaltverformung erfolgt zumeist durch Walzen. Der Verformungsgrad ist mit entscheidend für den resultierenden Texturierungsgrad und mittleren Verkippungswinkels der einzelnen Kristallite gegeneinander. Andererseits weisen die derart hergestellten Metallsubstratoberflächen eine relativ hohe Rauhigkeit auf. Dies ist für verschiedene Verfahren zur Herstellung von HTS-Schichtanordnungen, beispielsweise bei Gasphasenabscheidungen, noch akzeptabel, insbesondere bei Abscheidung von Schichten der HTS-Schichtanordnung durch chemische Lösungsbeschichtung wird bei derartigen Metallsubstraten jedoch ein unzulänglicher Texturübertrag festgestellt. Eine Vergrößerung des Walzenspaltes, der aufgrund geringerer Druckkräfte zu einem geringeren Walzenverschleiß und zu glatteren Oberflächen führen könnte, würde jedoch eine deutlich schlechtere Texturierung und Erhöhung der Verkippungswinkel an dem Metallsubstrat führen. Zwar können Metallsubstrate mit verbesserter Oberflächenqualität, welche auch einen erhöhten Texturübertrag bei chemischer Lösungsbeschichtung ermöglichen, unter Laborbedingungen hergestellt werden, beispielsweise durch Verwendung hochpolierter Walzen bei der Kaltverformung. Derartige Verfahren sind im industriellen Maßstab jedoch nicht anwendbar, da diese eine zu geringe Standzeit der Walzen bedingen würden, so dass diese Verfahren nicht mehr ökonomisch durchführbar wären. Bei Verwendung industriell hergestellter biaxial texturierter Metallsubstrate werden bei einer chemischen Lösungsbeschichtung jedoch trotz der guten Textur der Metallsubstrate nur amorphe oder wenig orientierte Aufwachsschichten des jeweiligen Materials der HTS-Schichtanordnung (z.B. des Puffermaterials) erhalten.

Der Erfindung liegt daher die Aufgabe zugrunde, ein Verfahren zur Herstellung von biaxial texturierten Metallsubstraten bereitzustellen, welches im industriellen Maßstab anwendbar ist und welches insbesondere bei chemischer Lösungsbeschichtung einen hohen Texturübertrag auf die auf dem Metallsubstrat abzuscheidende Schicht der HTS-Schichtanordnung ermöglicht.

Die EP 1653484 A1 beschreibt ein Verfahren zur Herstellung von HTS-Bändern, wobei eine Entgratung des Metallsubstrats durch ein Elektropolierung erfolgen kann, die Polierung zur Erzeugung der Substratoberfläche, auf welcher die nachfolgene Schicht epitaktisch abgeschieden wird, erfolgt durch eine mechano-chemische Polierung unter Verwendung einer Poliermittelaufschlämmung.

Die US 2005/0220986 A1 beschreibt die Herstellung von HTS-Artikeln, welche vor der Abscheidung einer Pufferschicht einer mechanischen Polierbehandlung unter Verwendung einer Poliermittelaufschlämmung unterzogen wird.

Die US 2005/0016867 A1 beschreibt die Herstellung von Superleiterschichten auf einem metallischen Substrat mit Elektropolierung, wobei auf dem Substrat ohne Nachglühung physikalische Verfahren der Hochvakuumtechnik eine Schicht aufgebracht wird.

Diese Aufgabe kann überraschenderweise durch ein verfahren nach Anspruch 1 gelöst werden, dass ein biaxial texturiertes Metallsubstrat einer Polierbehandlung unterworfen wird, und zwar einem Elektropolieren bis auf eine Oberflächenrauhigkeit Rms ≤ 15nm, und nachfolgend zu dieser einer Nachglühung unterworfen wird, bevor wahlweise, d.h. bei Bedarf, eine nachfolgende Beschichtung unter epitaktischer Abscheidung einer Schicht der HTS-Schichtanordnung durchgeführt wird, wobei die Nachglühung bei einer Temperatur von ≥ 850°C durchgeführt wird.

Zwar ist es bekannt, die Rauhigkeit von Metalloberflächen durch Polierung zu vermindern. Es hat sich jedoch herausgestellt, dass derartige polierte Metallsubstratoberflächen von biaxial texturierten Metallsubstraten nicht ein texturiertes Aufwachsen einer nachfolgenden Schicht der HTS-Schichtanordnung ermöglichen. Die Aufwachsschicht ist vielmehr in der Regel amorph oder weist im Hinblick auf die Erfordernisse einen unzureichenden Texturierungsgrad auf, insbesondere im Fall von chemischer Lösungsbeschichtung. Überraschenderweise wurde jedoch im Rahmen von umfangreichen Versuchen festgestellt, dass einen hohen Texturübertrag ermöglichende Metallsubstratoberflächen dadurch erhalten werden können, dass nachfolgend zu der Polierbehandlung das

Metallsubstrat einer Nachglühung unterworfen wird, bevor eine nachfolgende Beschichtung einer Schicht der HTS-Schichtanordnung unter epitaktischer Abscheidung derselben durchgeführt wird bzw. durchgeführt werden kann. Obwohl durch die Polierbehandlung eine an sich ausreichend glatte Oberfläche des biaxial texturierten Metallsubstrates erhalten werden kann, ist somit erst durch eine Nachglühung ein ausreichender Texturübertrag auf die unmittelbar folgende Aufwachsschicht erzielbar. Ohne durch die Theorie gebunden zu sein, wird angenommen, dass durch die Polierbehandlung die äußersten Atomlagen des texturierten Metallsubstrates eine Umstrukturierung, beispielsweise einer Amorphisierung oder partiellen Oxidation, unterliegen, die jedoch durch die kurzzeitige Nachglühung zumindest teilweise oder vollständig aufgehoben wird, durch welche zumindest eine Reorganisation oder Rekristallisation, ggf. in Verbindung mit einer Reduktion, der Metallsubstratoberfläche erfolgt. Hierbei kann die nach der Polierbehandlung erfolgende Nachglühung in der Regel über einen kürzeren Zeitraum erfolgen, als die Rekristallisationsnachglühung bei der Herstellung des biaxial texturierten Metallsubstrats nach der Kaltumformung, welche ca. 1 Stunde betragen kann. Erst durch die Kombination der beiden genannten Behandlungsschritte ist somit ein biaxial texturiertes Metallsubstrat erhältlich, welches insbesondere auch bei chemischer Lösungsbeschichtung einen sehr hohen Texturübertrag und damit eine sehr hohe Qualität der Aufwachsschicht bei sehr geringer Rauhigkeit der Metallsubstratoberfläche und somit auch geringer Anzahl von Gitterdefekten und gegebenenfalls sehr geringer Rauhigkeit der dem Metallsubstrat abgewandten Oberfläche der Aufwachschicht ermöglicht. Hierdurch können letztendlich auch Hochtemperatursupräleiterschichten verbesserter Qualität, insbesondere mit erhöhter Texturierung, verminderter Oberflächenrauhigkeit und/oder erhöhter kritischer Stromdichte, erzeugt werden.

Unter einem epitaktischen Aufwachsen sei hierbei ein kristallographisch orientiertes Aufwachsen verstanden, wobei bezogen auf die Substrat- bzw. Aufwachsebene das Kristallgitter der Aufwachsschicht dem des Metallsubstrats oder auch einer Überstruktur desselben entsprechen kann. Es kann eine Aufwachsschicht auf dem Metallsubstrat aufgebracht werden, deren Kristallgitter rotiert oder unrotiert zu dem Kristallgitter des Metallsubstrates angeordnet sein kann. Bei einem rotierten Aufwachsen der Aufwachsschicht schließen eine oder beide der kristallographischen Achsen der Aufwachsschicht zu den kristallographischen Achsen des Metallsubstrates in der Aufwachsebene (Ebene der Metallsubstratoberfläche) einen Winkel zueinander ein. Eine der kristallographischen Achsen der Kristallstruktur der Aufwachsschicht kann in (110)- oder (210)-Richtung der Kristallstruktur des Metallsubstrates, welche die Aufwachsebene definiert, angeordnet sein. Die oder eine der Gitterkonstante(n) der Aufwachsschicht kann einer oder beider der kristallographischen Achsen der Aufwachsschicht der (110)- oder (210)-Achse des Metallsubstrats entsprechen, gegebenenfalls auch einem ganzzahligen Vielfachen derselben, z. B. dem 2- oder 3-fachen.

Die Z-Achse ist hierbei jeweils quer oder senkrecht zu der Aufwachsebene des Metallsubstrats angeordnet. Diese Angaben beziehen sich jeweils auf die Kristallstruktur des Metallsubstrates, ohne Berücksichtigung der Bildung einer Überstruktur auf der Metallsubstratoberfläche, beispielsweise durch eine Nachglühbehandlung. Die Aufwachsschicht, die unmittelbar auf dem Metallsubstrat aufwächst, kann insbesondere kubisch (z.B. Fluorid-Typ, Pyrochlor-Typ, Mn203-Typ), tetragonal (z.B. La2NiO4-Typ), orthorhombisch (z.B. Perovskit-Typ) oder rhomboedrisch (z.B. Perovskit-Typ) kristallisieren, gegebenenfalls auch monoklin. Die Überstruktur der Wachstumsschicht in Bezug auf das Metallsubstrat ist somit insbesondere eine Metallsubstratüberstruktur in Bezug auf die Aufwachsebene. Es hat sich herausgestellt, dass das erfindungsgemäße Verfahren insbesondere bei rotiert aufwachsenden Aufwachsschichten zu einer sehr deutlichen Verbesserung des Texturübertrags von dem Metallsubstrat auf die Aufwachsschicht führt, insbesondere dann, wenn die Metallsubstratoberfläche (oberste Atomlage(n)) durch eine Überstruktur der Metallsubstratkristallstruktur ausgebildet wird. Unter Umständen ist das erfindungsgemäße Verfahren jedoch auch vorteilhaft einsetzbar bei Aufwachsschichten, welche in Bezug auf die Aufwachsebene keine Überstrukturen mit dem Kristallgitter des Metallsubstrates bilden und mit dem Metallsubstratgitter bis auf etwaige geringfügige Gitterfehlpassungen übereinstimmen.

Die Aufwachsschicht kann eine Pufferschicht oder eine andere Zwischenschicht, welche die Metallsubstratoberfläche ggf. nur teilweise bedecken kann, sein, beispielsweise eine Zwischenschicht mit Kristallisationsstellen für eine abzuscheidende Pufferschicht. Gegebenenfalls kann die Aufwachsschicht auf dem Metallsubstrat auch unmittelbar eine HTS-Schicht sein. Allgemein kann die auf dem Metallsubstrat erzeugte epitaktische Aufwachsschicht eine Metalloxidschicht sein (gegebenenfalls nach einer Glüh- und Kristallisationsbehandlung).

Das erfindungsgemäße Verfahren kann bei dem Verfahrensschritt der Nachglühung des oberflächenpolierten Metallsubstrats beendet oder unterbrochen werden, so dass das derart hergestellte Metallsubstrat zwischengelagert oder an einem anderen Ort mit den weiteren Schichten der HTS-Schichtanordnung beschichtet wird. Das Aufbringen der Aufwachsschicht kann sich auch unmittelbar an die Nachglühung anschließen.

Die Polierung kann allgemein im batch-Betrieb oder im Durchlaufbetrieb erfolgen. Auch die Nachglühung kann allgemein im batch-Betrieb oder im Durchlaufbetrieb erfolgen. Vorzugsweise erfolgen Polierung und Nachglühung im Durchlaufbetrieb, vorzugsweise unmittelbar hintereinander.

Die Polierbehandlung wird erfindungsgemäß als Elektropolieren durchgeführt. Hierdurch ist zum einen bei der Herstellung langgestreckter, z.B. draht- oder bandförmiger, Metallsubstrate bzw. HTS-Schichtanordnungen eine besonders günstige Integration des Elektropolierschrittes in den Herstellungsablauf möglich. Weiterhin hat es sich herausgestellt, dass aufgrund der Besonderheiten des Elektropolierens die polierten Oberflächen der biaxial texturierten Metallsubstrate besonders günstig sind, um HTS-Schichtanordnungen mit besonders günstigen Eigenschaften herzustellen, insbesondere auch im Hinblick auf den erforderlichen Texturübertrag vom Metallsubstrat auf die aufzuwachsenden Schichten der HTS-Schichtanordnung.

Das Elektropolieren kann unter Anwendung von Gleichstrom erfolgen, ggf. auch unter Einsatz gepulster Ströme. Es kann eine elektrochemische Anordnung gewählt werden, bei welcher das Metallsubstrat als Mittelleiter geschaltet ist, d. h. auf einem sogenannten Mittelpotential liegt, insbesondere wenn das zu polierende Metallsubstrat langgestreckt wie beispielsweise als Draht oder Band ausgebildet ist. Der Elektrolysestrom wird hierbei über vorzugsweise die gesamte Rückseite des Metallsubstrates in diese eingekoppelt, gegebenenfalls kann eine Einkoppelung nur über Teilbereiche der Rückseite erfolgen, die über die Längserstreckung des Substrats verteilt angeordnet seir können. Hierdurch wird die Elektropolierzelle in zwei Teilzellen geteilt. Besonderer Vorteil dieser Anordnung ist, dass der Elektrolysestrom bei der Elektropolierung nicht durch den sehr geringen Bandquerschnitt in Längsrichtung des Substrats fließen muss, was beispielsweise der Fall ist, wenn der Elektrolysestrom über gegenüber dem Metallsubstrat lageveränderliche Kontakte wie Rollen oder Schleifkontakte in das zu polierende Band eingebracht wird (auch wenn eine derartige Durchführung der Elektropolierung als solche prinzipiell möglich ist). Durch die Anordnung des Metallsubstrats als Mittelpotentialleiter lassen sich somit hohe Elektropolierströme realisieren, wodurch besonders vorteilhafte Metallsubstratoberflächen erhalten werden, sowie auch kurze Verweilzeiten und damit hohe Durchlaufgeschwindigkeiten in einem kontinuierlichen Polierverfahren der zumeist draht- oder bandförmigen Metallsubstrate.

Das Elektropolieren kann mit einer Stromdichte von 2-80 A/dm² oder gegebenenfalls auch höher erfolgen, vorzugsweise bei Stromdichten von ca. 5-50 A/dm² oder ca. 5-30 A/dm², besonders bevorzugt ca. 10-30 A/dm² oder ca. 10-20 A/dm².

Die Elektropolitur kann bei einer Elektrolyttemperatur von 20-70°C, vorzugsweise 30-60°C, besonders bevorzugt ca. 40-50°C erfolgen.

Die Elektropolitur kann für eine Dauer von ≤ 15 min oder ≤ 6-10 min, vorzugsweise ≤ 3-4 min, besonders bevorzugt innerhalb von 1-2 min oder weniger erfolgen, jeweils bezogen auf den zu elektropoliereriden Abschnitt des Metallsubstrates. Vorzugsweise erfolgt die Elektropolierung über eine Zeitdauer von ≤ 5 sec oder ≥ 10-15 sec, ≥ 20-30 sec oder ≥ 45 sec.

Der Elektrolyt kann Schwefelsäure und/oder eine Phosphorsäure enthalten. Die Phosphorsäure kann Orthophosphorsäure, eine Polyphosphorsäure, eine Metaphosphorsäure oder andere Phosphorsäure, einschließlich Kombinationen derselben, sein. Das Gewichtsverhältnis von Schwefelsäure/Phosphorsäure (Gesamtsumme Phosphorsäuren) kann im Bereich von 1 : 20 bis 20 : 1 oder 1 : 10 bis 10 : 1; von 1 : 6 bis 6 : 1; von 1 : 4 bis 4 : 1, vorzugsweise 1 : 3 bis 3 : 1 oder 1 : 2 bis 2 : 1 liegen, beispielsweise im Bereich von ca. 1 : 1. Der Elektrolyt kann einen pH-Wert von 1-4, vorzugsweise 2-3 aufweisen, ggf. auch einen pH-Wert von < 1.

Die Polierung, insbesondere Elektropolierung, kann auch in Gegenwart organischer Säuren erfolgen. Diese können ggf. anstelle von oder zusätzlich zu Schwefelsäure und/oder Phosphorsäure eingesetzt werden. Die organische Säure kann eine ein- oder mehrwertige Carbonsäure sein, beispielsweise eine C1-C6 oder C2-C4 Carbonsäure, beispielsweise Propionsäure. Es können gegebenenfalls auch andere organische Säuren eingesetzt werden, beispielsweise Sulfonsäuren, oder Kombinationen derselben. Eine bevorzugte Kombination von anorganischen und organischen Säuren ist eine Mischung aus Phosphorsäure, Schwefelsäure und Zitronensäure. Gegebenenfalls kann der Elektrolyt weitere komplexierende Stoffe in Bezug auf die bei der Elektropolitur von dem Metallsubstrat in Lösung gehenden Metallionen bzw. Chelatbildner, Oberflächeninhibitoren, oberflächenaktive Stoffe oder andere die Elektropolitur beeinflussende Stoffe enthalten.

Es wurde festgestellt, dass durch die Polierung, insbesondere Elektropolierung, nicht nur die Oberflächenrauhigkeit des Metallsubstrats wesentlich verbessert wurde, was sich für einen optimalen Texturübertrag als vorteilhaft herausgestellt hat, weiterhin wird die Metallsubstratoberfläche auch von Oberflächendefekten und organischen und/oder anorganischen oder anderen Verunreinigungen sowie von Prozesshilfsmitteln oder Resten von Prozesshilfsmitteln befreit, welche sich bei dem Aufwachsen der weiteren Schicht der HTS-Schichtanordnung störend bemerkbar machen würden, beispielsweise zu erhöhten Fehlstellen der Aufwachsschicht und zu einem schlechteren Texturübertrag führen würden.

Prozesshilfsmittel, die während des industriellen Fertigungsprozesses auf die Bänder aufgebracht werden, können insbesondere Walzhilfsmittel, wie Walzöle oder -seifen, sowie Trenn- und Antihaftmittelmittel, wie keramische Partikel oder Schichten, sein.

Es versteht sich, dass vor der Polierung, insbesondere der Elektropolierung, die Metallsubstratoberfläche einem Reinigungsschritt unterzogen werden kann. Die Reinigung kann unter Verwendung organischer Lösungsmittel, wie beispielsweise Alkohole, Ketone und/oder Ester und dergleichen erfolgen, welche in Kombination oder nacheinander zur Anwendung gebracht werden können, beispielsweise Isopropanol und/oder Aceton. Insbesondere kann die Metallsubstratoberfläche vor der Elektropolierung auch angeätzt werden, insbesondere unter Verwendung von Säuren wie organischer Säuren. Dies können beispielsweise Carbonsäuren wie C1- bis C6-Carbonsäuren, insbesondere C2- bis C4-Carbonsäuren sein, besonders bevorzugt Propionsäure. Die Carbonsäuren können auch mehrwertig sein, z.B. Weinsäure oder Zitronensäure. Die Behandlung des Metallsubstrats kann jeweils im Ultraschallbad erfolgen.

Eine Reinigung der Metallsubstratoberfläche vor der Polierung, insbesondere Elektropolierung, kann zusätzlich oder alternativ auch durch Anwendung tensidhaltiger Lösungen, insbesondere wässriger Tensidlösungen, erfolgen.

Eine der Polierung, insbesondere Elektropolierung, vorgeschaltete Oberflächenreinigung des Metallsubstrats kann auch durch eine Plasmareinigung, insbesondere eine UV-Plasmareinigung, erfolgen.

Die oben genannten Reinigungsschritte können jeweils auch in Kombination miteinander eingesetzt werden, beispielsweise in der genannten oder in einer anderen Reihenfolge.

Die Polierung erfolgt erfindungsgemäß bis zu einer Oberflächenrauhigkeit von Rms nach DIN EN ISO 4287 und 4288 von ≤ 15nm, vorzugsweise ≤ 12-13nm oder ≤ 10nm, besonders bevorzugt ≤ 7-8nm erfolgen. Die Rauhigkeiten beziehen sich jeweils auf ein Areal von 10x10µm innerhalb einer Korngrenze eines Kristallits der Substratoberfläche, so dass die Korngrenzen des Metallsubstrates die angegebene Rauhigkeit nicht verfälschen.

Wie oben bereits ausgeführt, hat es sich überraschenderweise herausgestellt, dass die durch Polierung erhaltenen Substratoberflächen zwar eine sehr geringe Oberflächenrauhigkeit, was an sich vorteilhaft ist für die aufzuwachsende Schicht der HTS-Schichtanordnung ist. Dennoch werden mit diesen vermeintlich optimalen Metallsubstraten Aufwachschichten mit völlig unzureichendem Texturübertrag erhalten. So wiesen die auf einem derartigen polierten Substrat erzeugten Aufwachsschichten nur eine sehr geringe Textur auf oder waren praktisch amorph. Dies gilt beispielsweise auch für Lanthanzirkonatschichten, wie sie beispielsweise nach der DE 10 2004 041 051 A1 oder auf andere geeignete Weise erhalten werden, oder für andere Pufferschichten wie z.B. Ceroxid usw. Dieses negative Ergebnis wurde gefunden, obwohl die EBSD (Electron Back Scattering Diffraction)-Analysen der polierten Substrate vergleichbare Ergebnisse mit unpolierten Substraten zeigten. Ein epitaktisches Aufwachsen konnte jedoch dennoch nicht festgestellt werden.

Überraschenderweise konnte jedoch ein sehr guter Texturübertrag von der polierten Metalloberfläche auf oxidische Aufwachsschicht der HTS-Schichtanordnung festgestellt werden, wenn das Metallsubstrat nach der Oberflächenpolierung und vor der Abscheidung der weiteren Schicht einer Nachglühung unterworfen wird. Die Nachglühung kann insbesondere bei einer geeigneten Temperatur über einen ausreichenden Zeitraum durchgeführt werden, so dass eine teilweise oder vorzugsweise zumindest praktisch vollständige Rekristallisation der Metallsubstratoberfläche erfolgt. Diese Rekristallisation umfasst vorzugsweise die obersten Atomlagen des Metallsubstrats, so dass beispielsweise eine Rekristallisation innerhalb einer Oberflächenschicht ausgehend von der Metallsubstratoberfläche mit einer Tiefe von 2-3 nm, vorzugsweise in einer Tiefe von 1,5-1 nm oder besonders bevorzugt einer Tiefe von 0,1-0,5 nm festgestellt wird. Besonders bevorzugt erfolgt somit durch die Nachglühung eine Rekristallisation der obersten Atomlagen des Metallsubstrats, beispielsweise eine Rekristallisation innerhalb der oberen 10-15 Atomlagen, vorzugsweise innerhalb der oberen 5-8 Atomlagen oder weniger. Die Kristallisation dieser oberen Atomlagen kann insbesondere durch RHEED-Messungen (reflective high electron energy diffraction) nachgewiesen werden, die im Gegensatz von EBSD-Analysen eine Charakterisierung der obersten Atomlagen des Metallsubstrats ermöglichen. Es hat sich somit als entscheidend herausgestellt, dass nach der Polierung des biaxial texturierten Metallsubstrats eine Rekristallisation der obersten Metalllagen des Substrats erfolgt, um ein epitaktisches Aufwachsen der nächsten Schicht der HTS-Schichtanordnung mit hohem Texturübertrag zu gewährleisten.

Die Nachglühung kann allgemein, insbesondere auch im Fall von Nickel und/oder Kupfer-Basis-Legierungen, bei einer Temperatur von ≥ 650°C-700°C durchgeführt werden, vorzugsweise bei Temperaturen von ≥ 750°C-800°C, besonders bevorzugt bei Temperaturen von ≥ 800°C-850°C, ≥ 900°C-950°C oder ≥ 1000°C. Die Nachglühung sollte nicht bei zu hohen Temperaturen erfolgen, um nicht einen nachteiligen Einfluss auf die Textur des Metallsubstrats zu haben. Die Nachglühung kann somit bei Temperaturen von ≤ 1.300°C-1.350°C, insbesondere ≤ 1.200°C-1.250°C, vorzugsweise bei Temperaturen von ≤ 1.150°C-1.100°C erfolgen, was insbesondere für Nickel und/oder Kupfer-Basis-Legierungen gilt.

Allgemein kann die Nachglühung in einem Temperaturbereich erfolgen, welcher niedriger als der Schmelzpunkt des jeweiligen Materials des Metallsubstrates (kongruenter oder inkogruenter Schmelzpunkt) ist, beispielsweise 50-700°C niedriger, ohne hierauf beschränkt zu sein, insbesondere in einem Temperaturbereich von 100-600°C niedriger oder 200-550°C niedriger als der Schmelzpunkt des Metallsubstrates.

Durch die erfindungsgemäße gezielte Orientierungsglühung der obersten Atomlagen des Metallsubstrats können diese somit wieder wie die tieferen Schichten des Metallsubstrats orientiert und texturiert werden, oder in Bezug auf die Kristallstruktur des Metallsubstrates in einer Überstruktur desselben kristallisieren, beispielsweise in einer kubischen oder orthorhombischen Überstruktur, insbesondere Schwefelüberstruktur (z.B. Atomanordnung entsprechend einer halben Monolage Schwefel (bzw. des entsprechenden Metallatoms mit c(2x2)-Überstruktur).

Es hat sich herausgestellt, dass die Nachglühung bei ausreichend hohen Temperaturen nur über einen sehr kurzen Zeitraum erforderlich ist, beispielsweise in einem Zeitraum von ≤ 12-15 min oder ≤ 8-10 min, beispielsweise auch ≤ 4-6 min oder ≤ 2-3 min, jeweils bezogen auf die Haltedauer bei der höchsten Temperatur oder bezogen auf die Gesamtverweildauer bei Temperaturen ≥ 650°C-700°C, ≥ 750°C-800°C oder vorzugsweise ≥ 800°C-850°C, ≥ 900°C-950°C oder besonders bevorzugt ≥ 1000°C. Es versteht sich, dass die erforderliche Nachglühzeit von der Nachglühtemperatur in Abhängigkeit von dem jeweiligen Metallsubstrat und somit dem Schmelzpunkt bzw. der Beweglichkeit der Atome der obersten Metalllagen des Substrats wesentlich abhängen kann.

Bei der der Polierung folgenden Nachglühung kann eine inerte, vorzugsweise eine reduzierende Atmosphäre eingesetzt werden, der Wasserstoffpartialdruck kann einem Wasserstoffgehalt der Atmosphäre von ≥ 10-25 Vol% oder ≥ 50-75 Vol%, vorzugsweise ≥ 85-90 Vol% oder ≥ 95-98 Vol% entsprechen, beispielsweise reiner Wasserstoff sein. Die übrigen Bestandteile können Stickstoff oder vorzugsweise Edelgase wie Argon oder Helium sein.

Die Nachglühung kann somit insbesondere derart erfolgen, dass die Oberfläche RHEED-analytisch zumindest teilkristallin oder gemäß dem angewandten Analyseverfahren zumindest praktisch vollständig kristallin ist. Die RHEED-Messungen können hierbei derart durchgeführt werden, dass die Informationstiefe überwiegend oder praktisch ausschließlich die obersten 2-3 oder 4-5 oder die obersten 6-8 oder 19 Atomlagen erfasst.

Das Metallsubstrat kann insbesondere eine Nickel- und/oder Kupfer-Basis-Legierung sein, die jeweils weitere Legierungsbestandteile enthalten können. Nickel-Basis-Legierungen können insbesondere Wolfram als Legierungsbestandteil enthalten, beispielsweise bis zu 14-25 Atom-% bezogen auf den Gesamtmetallgehalt der Legierung oder bis zu 5-9 Atom-% Wolfram. Die Legierungen können jeweils Legierungsbestandteile und/oder Zuschlagstoffe enthalten, welche die industrielle Fertigung, z. B. eine Umformung der Substrate, erleichtern (beispielsweise Magnesium, Aluminium, Bor) oder die Texturbildung beeinflussen, wie beispielsweise andere Metalle der ersten Übergangsmetallperiode, insbesondere Mangan und/oder Silber oder Seltenerdelemente, insbesondere Cer. Das Metallsubstrat kann auch eine Kupfer-Basis-Legierung darstellen, beispielsweise Konstantan, Hastelloy oder dergleichen, für welche im Übrigen das oben Gesagte gelten kann.

Auf das erfindungsgemäß hergestellte Metallsubstrat kann eine Pufferschicht epitaktisch abgeschieden werden, wobei das Metallsubstrat gegebenenfalls mit einer Zwischenschicht versehen sein kann, welche das Metallsubstrat nicht durchgehend bedeckt und in Form einer Vielzahl von Kristallisationskeimen für die aufzubringende Pufferschicht ausgebildet sein kann.

Die Pufferschicht kann insbesondere ein Metalloxid sein wie beispielsweise Seltenerden-Übergangsmetall-Oxide wie Seltenerdenzirkonatezirkonate (SE einschließlich Lanthan), z.B. Gadoliniumzirkonat, Lanthanzirkonat, Manganate wie Lanthanmanganate, Ruthenate wie Strontiumruthenat, Seltenerdenaluminate einschließlich Lanthanaluminat; Seltenerdenmetall-Cer-Oxide, wobei als Seltenerdenmetall Lanthan enthalten sein kann, insbesondere gemäß der deutschen Patentanmeldung DE 10 2008 016 257 A1, sowie andere Seltenerdenmetall-Seltenerdenmetalloxide wie z. B. Neodymgadoliniumoxid (z. B. NdGaO3); Hauptgruppenmetall-Übergangsmetall -Oxide wie Strontiumruthenat, Strontiumzirkonat, Calciumstrontiumtitanat, Bariumcalcium(strontium)titanat (oder allgemein gemischten Erdalkalimetalltitanaten mit 2 oder 3 Erdalkalimetallen aus der Gruppe Ca, Sr, Ba oder Mg, Ca, Sr, Ba wie z. B. EA1ₓEA2₁₋ₓTiO3 mit 0<x<1 oder allgemein (EA1, EA2, EA3) TiO3 mit EA=Erdalkalimetall), wobei bei den Erdalkalimetallverbindungen Titan teilweise oder vollständig durch eines oder mehrere andere Übergangsmetalle, insbesondere Übergangsmetalle der ersten Übergangsmetallperiode, ersetzt sein kann), oder Lanthannickeloxid (z.B. LaNiO3); binäre Metalloxide, vorzugsweise von Hauptgruppen- oder Übergangsmetallen wie Magnesiumoxid , Yttriumoxid, Zirkondioxid, Nickeloxid, Titandioxid, Yttrium-stabilisiertes Zirkonoxid (YSZ), Ceroxid oder andere Oxide wie LSMO (Lanthanstrontiummanganat), NdBCO (Neodymbariumcuprat) oder dergleichen, Gadoliniumoxid (z.B. Gd2O3), Europiumoxid (z.B. Eu2O3), Samariumoxid (z.B. Sm2O3), Neodymoxid (z.B. Nd2O3) usw.. Die Oxide können in Bezug auf den Sauerstoffgehalt und/oder den Metallgehalt auch nicht-stöchiometrisch sein, insbesondere unterstöchiometrisch. Im Hinblick auf die Metallteilgitter dieser Oxide können jeweils auch Mischkristallphasen auf Basis der oben genannten Oxide vorliegen, sowohl durch Mischatomlagen, Überstrukturen oder interstitielle Metallatome. Die Pufferschichtmaterialien können Übergangsmetalle, insbesondere der ersten Übergangsmetallgruppe enthalten, oder Metall oder Metalloxide, die bei Temperaturen ≤ 1600°C mit dem oxidischen Puffermaterial zumindest eine partielle Schmelze bilden, wozu auf die DE 10 2008 016 258 A1 verwiesen sei.

Gegebenenfalls kann die Aufwachsschicht auch aus anderen Oxiden bestehen, deren Kristallgitter mit dem des Metallsubstrates übereinstimmt, wie z.B. im Falle eines Substrates mit Nickelstruktur (auch Legierung) Strontiumtitanat (SrTiO3), Bariumtitanat (Ba-TiO3), Titannitrid (TiN) oder dergleichen.

Metallsubstrat bei den oben genannten Puffermaterialien kann insbesondere Ni oder Cu oder eine Ni-Legierung oder eine Cu-Legierung sein, welche jeweils insbesondere W und/oder Mo und/oder mindestens ein weiteres Übergangsmetall enthalten kann. Der Gehalt an W und/oder Mo und/oder des mindestens einem weiteren Übergangsmetalls (beispielsweise Fe, Cr und/oder Mn) kann ≥ 0,05% bis 0,1% oder ≥ 0,2% bis 0,5% oder ≥ 1% sein, der Gehalt kann jeweils ≤ 20% bis 25% oder ≤ 15% bis 17% oder ≤ 10% bis 12% sein (jeweils in at.-% bezogen auf die Gesamtlegierung).

Allgemein kann das erfindungsgemäße Verfahren bevorzugt eingesetzt werden, wenn das Pufferschichtmaterial eine Gitterfehlanpassung zu dem Metallsubstrat, auf welchem das Pufferschichtmaterial aufwächst, und/oder gegebenenfalls der auf dem Pufferschichtmaterial epitaktisch aufwachsenden Schicht (z.B. HTS-Schicht) aufweist. Die Gitterfehlanpassung bezieht sich hier jeweils auf das Verhältnis der Gitterkonstanten des Metallsubstrates oder der weiteren auf die Pufferschicht aufwachsenden Schicht zu der skalierten Gitterkonstanten der Pufferschicht, d.h. skaliert auf eine Einheitszelle der angrenzenden Schicht. Als Gitterkonstante des Metallsubstrates kann die Gitterkonstante des Bulkmaterials (Volumenmaterial ohne Berücksichtigung einer Überstruktur der obersten Atomlage(n)) angenommen werden oder ggf. unter Berücksichtigung einer etwaigen Überstruktur (z.B. Schwefelüberstruktur) der obersten obersten Atomlage. Die Gitterfehlanpassung kann hierbei jeweils ≤ ± 20-15%, vorzugsweise ≤ ± 10-12% oder ≤ ± 6-8% betragen, die Gitterfehlanpassung kann jeweils ≥ ± 0,5-1%, ≥ ± 2-4% oder auch ≥ ± 5% betragen (im Falle von La2Zr207 mit a₀(300K) 10,8 Å (= 1,08 nm) ergibt sich gegenüber Ni (a₀=3,52 Å = 0,352 nm, 300K) somit eine skalierte Gitterkonstante Lₘ von 3,81 Å (= 0, 381 nm) und somit eine Gitterfehlpassung von 7,61%). Durch das erfindungsgemäße Verfahren ist auch bei rotiertem Aufwachsen der Pufferschicht und Gitterfehlpassung ein besonders guter Texturübertrag und geringe Aufwachsfehler der Pufferschicht erzielbar.

Es wurde festgestellt, dass das erfindungsgemäß hergestellte Metallsubstrat insbesondere bei chemischer Lösungsbeschichtung mit einer Puffer- oder sonstigen Zwischenschicht einen sehr hohen Texturübertrag und damit ein epitaktisches Aufwachsen der Pufferschicht mit möglichst geringen Fehlstellen ermöglicht. Die chemische Lösungsbeschichtung kann insbesondere unter Verwendung von Carbonsäuresalzen (insbesondere Propionaten und/oder Pivalinaten) der jeweiligen Metalle erfolgen, wobei die Carbonsäuresalze teilweise oder vollständig fluoriert sein können, beispeilsweise in Form von Trifluoracetaten. Metallsalze (in Bezug auf die abzuscheidenden Metalle) von nicht-fluorierten, teilweise oder vollständig fluorierten Carbonsäuren können nacheinander oder gleichzeitig bei Abscheidungsschritten eingesetzt werden. Insbesondere sei hierzu verwiesen auf die DE 10 2004 038 030 B4 (insbesondere Beispiel 1), die US 5,656,382 und Beispiel 3 der DE 10 2004 041 053.

Gegebenenfalls kann die chemische Lösungsbeschichtung jedoch auf andere geeignete Weise erfolgen. Bei der chemischen Lösungsbeschichtung werden allgemein geeignete Precursor (z.B. geeignete Metallkomplexe) aus einer geeigneten Lösung, z.B. einer wässrigen Lötung, auf das Substrat aufgebracht, getrocknet und nachfolgend pyrolysiert (vorzugsweise unter Bildung von Oxiden) und kristallisiert, wobei Trocknung, Pyrolyse und Kristallisation ggf. auch gleichzeitig oder unmittelbar hintereinander durchgeführt werden können.

Die auf dem Metallsubstrat abgeschiedenen Metalloxidschichten der HTS-Schichtanordnung können in ihren EBSD-Analysen nahezu denen der Metallsubstrate entsprechen, wobei eine leichte Verschlechterung der Indizierungsrate von ≤ 5-7% oder ≤ 3-4% vorliegen kann. Die Indizierungsrate des Metallsubstrats kann ≥ 93-94% oder ≥ 95-96% oder ≥ 97-98% betragen.

Die Erfindung umfasst somit auch ein Verfahren zur Herstellung einer HTS-Schichtanordnung, bei welcher auf einem mittels des erfindungsgemäßen Verfahrens hergestellten biaxial texturierten Metallsubstrats epitaktisch eine Pufferschicht und/oder eine andere Zwischenschicht und/oder eine Hochtemperatursupraleiterschicht aufgebracht wird. Die Hochtemperatursupraleiterschicht kann gegebenenfalls unmittelbar auf der Metallsubstratoberfläche aufgebracht werden, vorzugsweise auf einer Pufferschicht, welche unmittelbar auf dem erfindungsgemäßen Metallsubstrat oder auf einer weiteren Pufferschicht abgeschieden sein kann, so dass die Pufferschicht auch aus einer Abfolge mehrer Schichten bestehen kann. Weiterhin umfasst die Erfindung eine HTS-Schichtanordnung, bei welcher auf einem mittels des erfindungsgemäßen Verfahrens hergestellten biaxial texturierten Metallsubstrats epitaktisch eine Pufferschicht und/oder eine andere Zwischenschicht und/oder eine Hochtemperatursupraleiterschicht direkt, d.h. unmittelbar, oder indirekt, d.h. unter Anordnung einer (weiteren) Zwischenschicht, aufgebracht ist. Die Schichtanordnung kann jeweils eine HTS-Schichtanordnung umfassen, zur epitaktischen Aufbringung einer solchen angepasst sein oder noch keine HTS-Schicht umfassen.

Der Hochtemperatursupraleiter kann insbesondere ein YBCO-Material (Y-Ba-Cu-O) bzw. ein SEBCO-Material (SE-Ba-Cu-O), ein BiSr-Material (Bi-Sr-Ca-Cu-O) oder auch ein anderes HTS-Material sein. Unter einem Hochtemperatursupraleiter sei hier ein solcher mit einer Sprungtemperatur von ≥ 77 Kelvin verstanden.

Die Erfindung wird nachfolgend beispielhaft beschrieben und anhand der Figuren erläutert. Es zeigen:
- Fig. 1:: Oberflächentexturkarte nach EBSD-Analyse eines Metallsubstrates mit Texturdiagramm,
- Fig. 2:: AFM Messung des Oberflächenprofils eines Metallsubstrates (links) mit 3D Darstellung (rechts),
- Fig. 3:: Röntgenbeugungsdiagramme von Lanthanzirkonat-Pufferschichten auf einem Metallsubstrat nach Abbildung 1 nach Elektropolitur mit (Kurve 1, erfindungsgemäß) und ohne Oberflächenglühung (Kurve 2),
- Fig. 4:: AFM Messung des Oberflächenprofils eines Metallsubstrats nach Abbildung 1 nach erfindungsgemäßer Polierung,
- Fig. 5:: schematische Darstellung einer Elektropolierungszelle mit zwei Teilzellen und der Anordnung des Metallsubstrats auf Mittelpotential

Die Herstellung des erfindungsgemäßen Metallsubstrats für eine Hochtemperatur-Schichtanordnung geht aus von einem industriell hergestellten biaxial texturierten Metallsubstrat, beispielsweise in Form eines Bänder oder Drahtes.

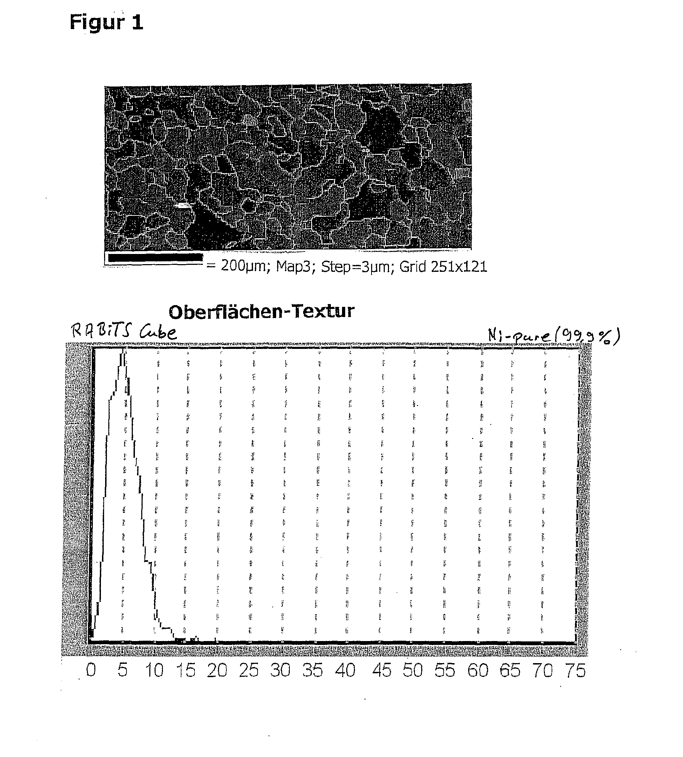

Das Metallsubstrat nach dem Ausführungsbeispiel besteht aus einer Nickellegierung mit 14 Gew.-% Wolfram und 100ppm Magnesium. Das Material wurde im Vakuumofen erschmolzen, anschließend warmgewalzt, beispielsweise bis auf eine Dicke von 5mm oder 3mm und anschließend kaltgewalzt, vorzugsweise unter Verringerung der Materialdicke mit Abwalzgraden von 5-40% oder 10-30%, insbesondere mit Abwalzgraden von ca. 20%, so dass ausgehend von dem oben genannten Material die Materialdicke ca. 80µ oder ca. 60µm betragen kann. Der Abwalzgrad entspricht hierbei dem Umformgrad in Blechdickenrichtung. Die Kaltverformung betrug somit ≥ 95 Vol.-%. Das derart erhaltene Band kann mittels einer Schneidwalze auf die gewünschte Breite geschnitten werden. Das derart erhaltene Material wurde einer Glühung bei Temperaturen oberhalb von 700°C-800°C, im speziellen im Bereich von 850°C-1.100°C für eine für eine zur Rekristallisation ausreichende Zeitdauer von beispielsweise ca. 1 Stunde oder länger unterworfen. Hierdurch werden hochgradige texturierte Metallsubstrate erhalten, bei denen der mittlere Verkippungswinkel der Kristallite gegeneinander ≤ 4-5°betragen kann. Eine EBSDanalytische Abbildung einer derartigen Substratoberfläche ist in Figur 1 dargestellt.

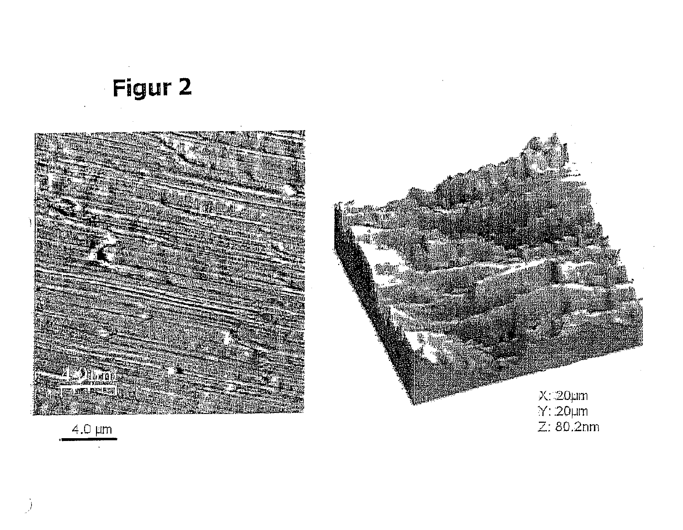

Figur 2 zeigt eine AFM (Atomkraftfeldmikroskopie)-Aufnahme bzw. ein Oberflächenprofil eines derart industriell hergestellten biaxial texturierten Metallbandes nach Fig. 1, wobei eine Vielzahl tiefer Kratzer und Walzspuren auf der Metallsubstratoberfläche erkennbar sind. Die Rauhigkeit nach der Walzung wurde mittels eines Atomkraftfeldmikroskops (AFM) mit Rms von ca. 19 nm bestimmt, das Messareal betrug hierbei 20x20 µm.

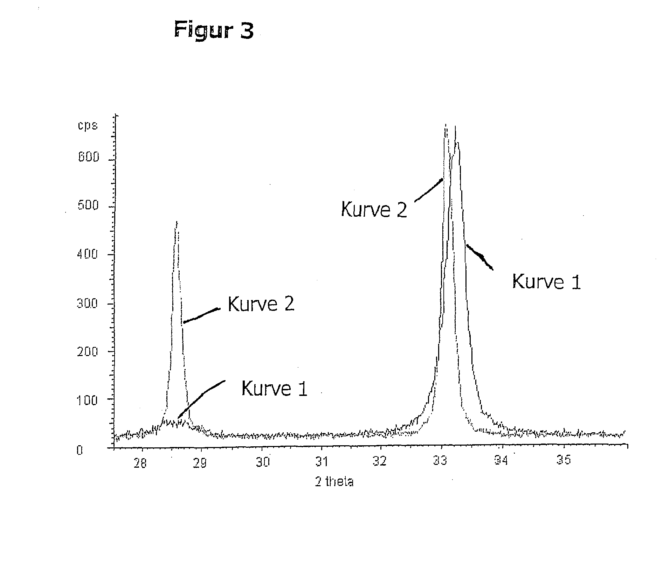

Allerdings hat es sich herausgestellt, dass auf Metallsubstratoberflächen gemäß Figur 2 abgeschiedene Pufferschichten, insbesondere unter Verwendung chemischer Lösungsabscheidung, nur amorphe oder wenig orientierte Schichten ergeben. So zeigt Figur 3, Kurve 1, ein RöntgenbeugungsDiagramm einer auf einer Metallsubstratoberfläche nach Figur 1 abgeschiedenen Lanthanzirkonat-Pufferschicht hergestellt gemäß Beispiel 1 der DE 10 2004 038 030 B4 oder Beispiel 3 (Seite 7) der DE 10 2004 041 053 A1.

Erfindungsgemäß wurden nach dem Ausführungsbeispiel zur Erzeugung biaxial texturierter Metallsubstrate, welche zum epitaktischen Aufwachsen von Puffer- oder anderen Schichten zur Herstellung von Hochtemperatursupraleiterschichtanordnungen geeignet sind, die oben beschriebenen Metallsubstrate nach Figur 1,2 mit der gezeigten Oberflächenstruktur verwendet.

Die Substratoberfläche wurde zunächst einer Reinigung unterworfen, welche jedoch unter Umständen nicht zwingend notwendig ist. Die Reinigung kann als Ultraschallreinigung durchgeführt werden, beispielsweise mit Lösungsmitteln, insbesondere organischen Lösungsmitteln wie Alkoholen, Ketonen, organischen Säuren, insbesondere Carbonsäuren wie z. B. Propionsäure und dergleichen. Alternativ oder zusätzlich können auch physikalische Reinigungsmethoden wie UV-Plasmareinigung durchgeführt werden.

Nachfolgend zu der gegebenenfalls durchgeführten Reinigung wird die Metallsubstratoberfläche einer Polierbehandlung unterworfen, nach dem Ausführungsbeispiel einer elektrochemischen Polierbehandlung.

Das Elektropolieren kann in einem sauren Polierbad erfolgen. Das Polierbad kann eine oder mehrere der Säuren ausgewählt aus der Gruppe Schwefelsäure, Phosphorsäure, organische Säuren, insbesondere Carbonsäuren, enthalten. Im vorliegenden Fall bestand das Polierbad aus den Hauptkomponenten Schwefelsäure/Orthophosphorsäure (Elektrolyt (E 260) der Fa. Poligrat GmbH, München). Vergleichbare Ergebnisse wurden mit Elektrolyten auf der Basis ausschließlich organischer Säuren erreicht, z.B. dem Elektrolyt E520 der Fa. Poligrat.

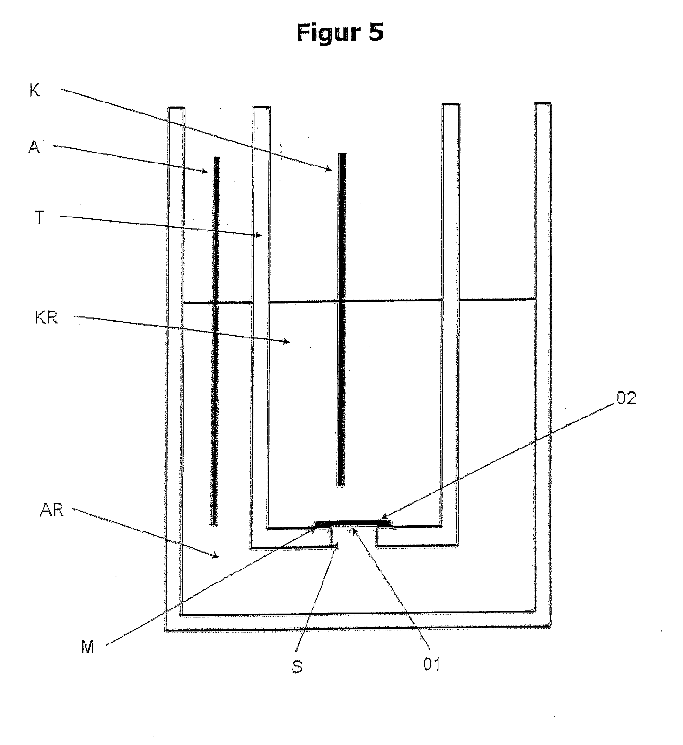

Das Polierbad kann wie in Figur 5 dargestellt aufgebaut sein. Der Kathodenraum KR (Teilzelle 1) mit der Kathode K kann von dem Anodenraum AR (Teilzelle 2) mit der Anode A durch die Trennwand T abgetrennt sein. Die Trennwand kann einen Spalt S aufweisen, der von dem zu elektopolierenden Metallsubstrat M, welches hier ein Metallband ist, geschlossen werden kann. Das Metallsubstrat trennt somit Anoden- und Kathodenraum vorzugsweise zumindest im Wesentlichen flüssigkeitsdicht, wobei eine Oberseite 01 des Metallsubstrats im Anodenraum und eine andere bzw. die gegenüberliegende Oberseite 02 des Metallsubstrats im Kathodenraum angeordnet ist. Der Elektrolysestrom durchdringt somit das Metallband, insbesondere die zu elektropolierende Metallsubstratoberseite im Anodenraum.

Zwei Proben des derart erhaltenen Materials wurden mit unterschiedlichen Prozessen rekristallisiert:

### Probe A:

Glühung einer 1m Probe unter 100% Wasserstoff für eine Stunde bei 1.000°C in einem Laborrohrofen im batch-Betrieb.

### Probe B:

Glühung von 10m in einem kontinuierlichen Rohrofen mit einer Durchzugsgeschwindigkeit von 2m/h und einer Verweilzeit von einer Stunde bei 1.050°C und einer reduzierenden Atmosphäre, beispielsweise 100% Wasserstoff.

### Probe C:

Zur Verbesserung der Handhabung und zur Verhinderung von Anhaftungen bei hohen Temperaturen wurde ein 100m langes Band mit einer Suspension mit MgO Partikeln mit einer Größe von d50 ≈ 5µm beschichtet. Das Band wurde anschließend wie Probe B prozessiert.

Die beiden Proben A und B zeigten sehr gute EBSD (Electron Back Scattering Diffraction)-Ergebnisse. Bei beiden Proben lag der Anteil der Messpunkte (MP) innerhalb von 10% Fehlorientierung bei über 99%, der Anteil MP innerhalb von 5% Fehlorientievung bei über 80%. Der Indizierungsgrad der beiden Proben betrug > 95%.

Die anschließende Abscheidung der Pufferschichten aus Zanthanzirkonat (La₂Zr₂O-_{7±x}) auf dem derart behandelten Metallsubstrat erfolgte mittels chemischer Lösungsbeschichtung, beispielsweise im Tauchverfahren. Die Beschichtung erfolgte jeweils als Standardbeschichtung.

Als Beschichtungslösung wurde Lanthan(III)propionat und Zirkon(IV)propionat in jeweils einer 0,4 molaren Lösung in Proprionsäure verwendet. Alternativ kann gegebenenfalls auch eine Lösung von Lanthan(III)pentandionat und Zirkon(IV)pentandionat in jeweils einer Lösung in Acetylaceton verwendet werden, beispielsweise jeweils einer 0,2 molaren Lösung in Bezug auf La2Zr2O7.

Anschließend erfolgte eine Trocknung unter Anwendung erhöhter Temperatur für einen ausreichenden Zeitraum, beispielsweise bei Temperaturen im Bereich von 100-500°C, beispielsweise 100-350°C oder bei ca. 150-200°C. Die Trocknung (ohne Zersetzung) erfolgte unter Luft. Nachfolgend zu der Trocknung wurde eine Kristallisation des Pufferschichtmaterials durchgeführt, beispielsweise bei 1.000-1.050°C unter reduzierenden Bedingungen, beispielsweise unter Formiergas (1-5 Vol.-% H2 in N2). Die Kristallisationsdauer betrug 45 min.

Allgemein kann die Beschichtung beispielsweise auch gemäß Beispiel 1 (Seite 6) der DE 10 2004 038 030 B4 oder Beispiel 3 der DE 10 2004 041 053 A1 erfolgen.

Die Beschichtungen und Glühprozesse erfolgten entweder, an Kurzproben (10cm) oder kontinuierlich an Bändern bis zum 10m Länge. Die Ergebnisse waren in beiden Verfahren vergleichbar.

Die derart erhaltenen Lanthanzirkonat-Pufferschichten waren bei keiner der beiden Proben orientiert bzw. texturiert (es wurden Röntgenbeugungs-Diagramme entsprechend Fig. 3, Kurve 1, erhalten).

Probe C konnte aufgrund der Beschichtung mit MgO nicht sinnvoll analysiert und beschichtet werden.

Anschließend wurden die oben beschriebenen Proben A, B und C alternativ einem erfindungsgemäßen Verfahren unterworfen.

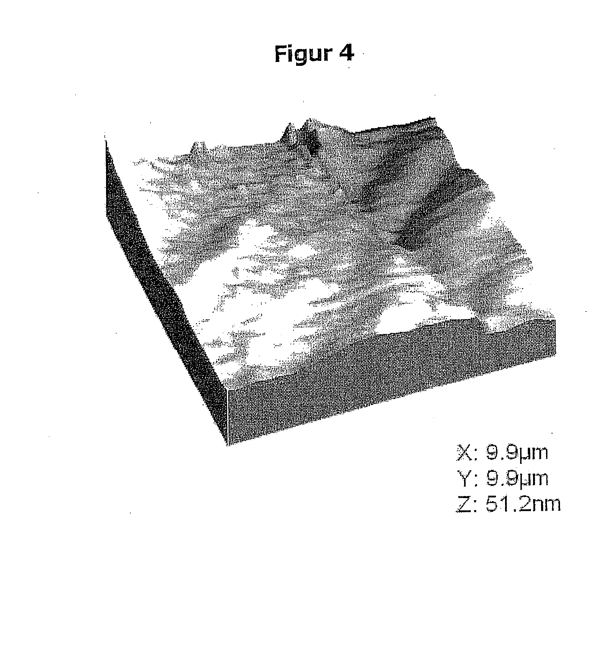

Die beiden Proben wurden in einem Ultraschallbad zunächst gereinigt, beispielsweise unter Verwendung organischer Lösungsmittel wie Isopropanol, Aceton oder dergleichen. Nach dem Ausführungsbeispiel erfolgte zunächst eine Reinigung mit Isopropanol, anschließend mit Aceton. Die Verweilzeit in dem Ultraschallbad betrug jeweils ca. 5 min. Eine weitere Probe C wurde zusätzlich der zuvor beschriebenen Reinigung im Ultraschallbad mit einer organischen Säure, beispielsweise Propionsäure (10%-ig) über eine Zeitdauer von ca. 10 min angeätzt. Die Reinigung der beiden Proben B und C erfolgte in einer Durchlaufapparatur, die Reinigung der Probe A im batch-Betrieb. Alle Proben A, B, C wurden anschließend in einer kontinuierlichen Elektropolieranlage poliert. Die Politur erfolgte mit einem sauren Elektrolyt, beispielsweise auf Schwefelsäure-Phosphorsäure-Zitronensäure Basis mit einer bevorzugten Zusammensetzung von 25-40% Schwefelsäure, 50-70% Phosphorsäure und 1-20% Zitronensäure. Die Badtemperatur betrug 40-50°C, die Stromdichte 15 A/dm². Die Elektropolierung erfolgte über einen Zeitraum von ca. 1 min. Die Elektropolitur erfolgte bei Anordnung des biaxial texturierten Metallsubstrats auf einem Mittelpotential, ohne dass dies immer zwingend notwendig ist (zur Anordnung der Elektropolierzelle siehe Figur 4). Der Elektrolysestrom wurde hierbei über die gesamte Bandrückseite in das Band eingekoppelt, so dass durch das Band die Elektropolierzelle in zwei Teilzellen geteilt wurde.

Alle Proben A, B, C zeigten nach dieser Behandlung einer Rauhigkeit von Rmn ≤ 10nm (Messung mittels Atomkraftfeldmikroskop AFM, Messareal 10x10µm).

EBSD-Analysen dieser Proben entsprachen denen vor der Polierung hinsichtlich der Indizierungsrate der Metallsubstratoberfläche.

Auf allen Proben A, B, C wurde wie oben eine Standardbeschichtung durchgeführt, auf keiner der Proben konnte eine orientierte Lanthanzirkonat-Pufferschicht erhalten werden.

Nach einer weiteren Variante wurden die wie oben beschriebenen elektropolierten Proben A, B, C nach der Elektropolierung einer erneuten Glühung unterzogen. Die Glühung erfolgte bei 1.000°C unter reduzierender Atmosphäre, beispielsweise 100% Wasserstoff. Probe A wurde in einem Labor-Batch-Ofen geglüht. Die Glühung erfolgte mit einer Aufheizzeit von einer Stunde und einer Abkühlzeit von zwei Stunden, ohne Haltezeit bei 1.000°C. Die Proben B und C wurde in einer Durchlaufglühanlage ebenfalls unter einer reduzierenden Atmosphäre, beispielsweise von 100% Wasserstoff geglüht. Die Verweilzeit bei der Maximaltemperatur betrug ca. 1-5 min. Die Maximaltemperatur betrug zwischen 850-1.100°C. In diesem Temperaturbereich ergaben sich vergleichbare Ergebnisse für unterschiedliche Proben.

An allen Proben A, B, C wurde eine Pufferbeschichtung unter den oben beschriebenen, unveränderten Standardbedingungen durchgeführt. Auf allen Proben konnte nunmehr eine kristalline und orientierte Pufferschicht aus Lanthanzirkonat nachgewiesen werden. Das Röntgenbeugungsdiagramm ist in Figur 3, Kurve 1, dargestellt, der Unterschied zu Kurve 2 ist augenfällig. Das gewünschte epitaktische Aufwachsen der Lanthanzirkonatschicht lässt sich an dem Verschwinden des Fehltexturpeaks bei 28,6° 2θ ablesen. Die Höhe des [222] Reflexes bei 28,6° 2θ ist ein direktes Maß für die Güte des Texturübertrages. Im Idealfall soll nur der [004] Reflex bei 33,2.° 2θ detektiert werden können. Die EBSD-Analysen entsprachen im Wesentlichen denen der Metallsubstrate, wobei eine geringe Verschlechterung der Werte von < 5% festgestellt wurde, wie sie für chemische Beschichtungsprozesse üblich ist.

RHEED-Messungen der Metallsubstrate nach der erneuten Glühbehandlung zeigten - im Gegensatz zu elektropolierten Proben ohne derartige Glühbehandlung - eine Rekristallisation der obersten Atomlagen des Metallsubstrats.

Auf den erfindungsgemäß hergestellten Pufferschichten der Proben A, B, C können eine oder mehrere weitere Pufferschichten aufgebracht werden, wobei das Material der jeweils weiteren aufgebrachten Pufferschicht(en) unabhängig voneinander dasselbe Pufferschichtmaterial wie das der ersten erfindungsgemäß aufgebrachten Pufferschicht sein kann, oder ein anderes Material. Unmittelbar auf der erfindungsgemäß aufgebrachten Pufferschicht oder auf einer weiteren abgeschiedenen Pufferschicht kann eine Hochtemperatursupraleiterschicht, beispielsweise aus einem YBCO-Material oder einem anderen keramischen Hochtemperatursupraleitermaterial wie z.B. eines BiCaSr-HTS-Materials, aufgebracht sein. Die Erfindung umfasst die weiteren derart hergestellten Schichtanordnungen.

## Patentansprüche

1. Verfahren zur Herstellung eines biaxial texturierten Metallsubstrats mit einer Metalloberfläche, wobei das Substrat zur Herstellung einer Hochtemperatursupraleiter (HTS)-Schichtanordnung angepasst ist und wobei die Metalloberfläche angepasst ist, um auf dieser epitaktisch eine Schicht der Hochtemperatursupraleiteranordnung abzuscheiden, wobei:
- ein biaxial texturiertes Metallsubstrat hergestellt wird,
- die Metallsubstratoberfläche einer Polierbehandlung unterworfen wird, welche als Elektropolieren ausgeführt wird bis auf eine Oberflächenrauhigkeit Rms ≤ 15nm,
- und das Metallsubstrat nach der Polierbehandlung einer Nachglühung unterworfen wird, bevor wahlweise eine nachfolgende Beschichtung unter epitaktischer Abscheidung einer Schicht der HTS-Schichtanordnung durchgeführt wird, wobei die Nachglühung bei einer Temperatur von ≥ 850°C durchgeführt wird.

2. Verfahren nach Anspruch 1, **dadurch gekennzeichnet, dass** das Elektropolieren mit einer Anordnung des zu polierenden Metallsubstrats auf einem Mittelpotential erfolgt.

3. Verfahren nach Anspruch 1 oder 2, **dadurch gekennzeichnet, dass** das Elektropolieren mit einer Stromdichte von 2 bis 80 A/dm² durchgeführt wird.

4. Verfahren nach einem der Ansprüche 1 bis 3, **dadurch gekennzeichnet, dass** vor dem Polieren eine Oberflächenätzung unter Verwendung organischer Säuren durchgeführt wird.

5. Verfahren nach einem der Ansprüche 1 bis 4, **dadurch gekennzeichnet, dass** die Elektropolierung des jeweiligen Oberflächenabschnittes über einen Zeitraum von ≤ 15 min erfolgt.

6. Verfahren nach einem der Ansprüche 1 bis 5, **dadurch gekennzeichnet, dass** das Nachglühen bei einer geeigneten Temperatur über einen ausreichenden Zeitraum durchgeführt wird, so dass eine Rekristallisation der Metallsubstratoberfläche erfolgt.

7. Verfahren nach einem der Ansprüche 1 bis 6, **dadurch gekennzeichnet, dass** die Nachglühung für einen Zeitraum von ≤ 15 min bezogen auf den jeweiligen Oberflächenabschnitt erfolgt.

8. Verfahren nach einem der Ansprüche 1 bis 7, **dadurch gekennzeichnet, dass** die Nachglühung unter einer reduzierenden Atmosphäre erfolgt.

9. Verfahren nach einem der Ansprüche 1 bis 8, **dadurch gekennzeichnet, dass** die Nachglühung derart erfolgt, dass die Oberfläche RHEED-analytisch zumindest teilkristallin ist.

10. Verfahren nach einem der Ansprüche 1 bis 9, **dadurch gekennzeichnet, dass** das Substrat eine Nickel- und/oder Kupfer-Basislegierung ist.

11. Verfahren zur Herstellung einer Hochtemperatursupraleiter (HTS)-Schichtanordnung oder eines Vorproduktes (Schichtanordnung nicht umfassend eine HTS-Schicht), bei welchem auf einem mittels des Verfahrens nach einem der Ansprüche 1 bis 10 hergestellten biaxial texturierten Metallsubstrat epitaktisch eine Pufferschicht und/oder eine andere Zwischenschicht und/oder eine Hochtemperatursupraleiterschicht jeweils direkt oder indirekt aufgebracht wird, und dass die Pufferschicht oder Zwischenschicht und/oder die HTS-Schicht durch chemische Lösungsbeschichtungen aufgebracht wird.

12. Verfahren nach Anspruch 10 oder 11, **dadurch gekennzeichnet, dass** eine Pufferschicht auf dem Metallsubstrat epitaktisch aufgebracht wird, welche kristallographisch in rotierter Anordnung gegenüber dem Metallsubstrat auf diesem aufwächst.

13. Biaxial texturiertes Metallsubstrat oder Schichtanordnung hergestellt nach einem Verfahren nach einem der Ansprüche 1 bis 12.

## Claims

1. A method for producing a biaxially textured metal substrate having a metal surface, the substrate being adapted to produce a high-temperature superconductor (HTS) coating arrangement and the metal surface being adapted to deposit a layer of the high-temperature superconductor coating arrangement epitaxially thereon:
- a biaxially textured metal substrate being produced,
- the metal substrate surface being subjected to a polishing treatment, which is performed as electropolishing to a surface roughness of rums ≤ 15 nm,
- and
after the polishing treatment, the metal substrate is subjected to a post-annealing before optionally a subsequent coating is carried out involving epitaxial deposition of a layer of the HTS coating arrangement, the post-annealing being carried out at a temperature of ≥ 850°C.

2. The method according to claim 1, wherein the electropolishing is performed with the metal substrate to be polished arranged at a medium potential.

3. The method according to claim 1 or 2, wherein the electropolishing is carried out with a current density of 2 to 80 A/dm².

4. The method according to one of claims 1 to 3, wherein, before the polishing, a surface etching treatment is carried out using organic acids.

5. The method according to one of claims 1 to 4, wherein the electropolishing of the respective surface portion is performed over a time period of ≤ 15 min.

6. The method according to one of claims 1 to 5, wherein the post-annealing is carried out at a suitable temperature over a sufficient time period such that a re-crystallization of the metal substrate surface takes place.

7. The method according to one of claims 1 to 6, wherein the post-annealing is performed with respect to the respective surface portion over a time period of ≤ 15 min.

8. The method according to one of claims 1 to 7, wherein the post-annealing is performed under a reducing atmosphere.

9. The method according to one of claims 1 to 8, wherein the post-annealing is performed in such a way that, under RHEED analysis, the surface is at least partially crystalline.

10. The method according to one of claims 1 to 9, wherein the substrate is a nickel- and/or copper-based alloy.

11. A method for producing a high-temperature superconductor (HTS) coating arrangement or a precursor (a coating arrangement not comprising an HTS layer), in which a buffer layer and/or another intermediate layer and/or a high-temperature superconductor layer is epitaxially applied, in each case directly or indirectly, on a biaxially textured metal substrate produced by means of the method according to one of claims 1 to 10, and wherein the buffer layer or intermediate layer and/or the HTS layer is applied by chemical solution coatings.

12. The method according to claim 10 or 11, wherein a buffer layer is epitaxially applied on the metal substrate and grows in a rotated arrangement with respect to the metal substrate crystallographically thereon.

13. A biaxially textured metal substrate or coating arrangement produced by a method according to one of claims 1 to 12.

## Revendications

1. Procédé de fabrication d'un substrat métallique à texturation biaxiale comprenant une surface métallique, le substrat étant adapté pour la fabrication d'un agencement stratifié supraconducteur à haute température (HTS) et la surface métallique étant adaptée pour le dépôt épitactique sur celle-ci d'une couche de l'agencement supraconducteur à haute température,
- un substrat métallique à texturation biaxiale étant fabriqué,
- la surface du substrat métallique étant soumise à un traitement de polissage, qui est configuré sous la forme d'un électropolissage, jusqu'à l'obtention d'une rugosité de surface Rms ≤ 15 nm,
et
- le substrat métallique étant soumis à un recuit après le traitement de polissage, avant éventuellement un revêtement ultérieur par dépôt épitactique d'une couche de l'agencement stratifié HTS, le recuit étant réalisé à une température ≥ 850 °C.

2. Procédé selon la revendication 1, **caractérisé en ce que** l'électropolissage a lieu avec un agencement du substrat métallique à polir à un potentiel neutre.

3. Procédé selon la revendication 1 ou 2, **caractérisé en ce que** l'électropolissage est réalisé avec une densité de courant de 2 à 80 A/dm².

4. Procédé selon l'une quelconque des revendications 1 à 3, **caractérisé en ce qu'**une gravure de surface est réalisée en utilisant des acides organiques avant le polissage.

5. Procédé selon l'une quelconque des revendications 1 à 4, **caractérisé en ce que** l'électropolissage de chaque section de la surface a lieu pendant une durée ≤ 15 minutes.

6. Procédé selon l'une quelconque des revendications 1 à 5, **caractérisé en ce que** le recuit est réalisé à une température appropriée pendant une durée suffisante pour qu'une recristallisation de la surface du substrat métallique ait lieu.

7. Procédé selon l'une quelconque des revendications 1 à 6, **caractérisé en ce que** le recuit a lieu pendant une durée ≤ 15 minutes pour chaque section de surface.

8. Procédé selon l'une quelconque des revendications 1 à 7, **caractérisé en ce que** le recuit a lieu dans une atmosphère réductrice.

9. Procédé selon l'une quelconque des revendications 1 à 8, **caractérisé en ce que** le recuit a lieu de sorte que la surface soit au moins partiellement cristalline par analyse RHEED.

10. Procédé selon l'une quelconque des revendications 1 à 9, **caractérisé en ce que** le substrat est un alliage à base de nickel et/ou de cuivre.

11. Procédé de fabrication d'un agencement stratifié supraconducteur à haute température (HTS) ou d'un produit préliminaire (agencement stratifié ne comprenant pas de couche HTS), selon lequel une couche tampon et/ou une autre couche intermédiaire et/ou une couche de supraconducteur à haute température est appliquée de manière épitactique à chaque fois directement ou indirectement sur un substrat métallique à texturation biaxiale fabriqué par le procédé selon l'une quelconque des revendications 1 à 10, et selon lequel la couche tampon ou la couche intermédiaire et/ou la couche HTS est appliquée par des revêtements en solution chimiques.

12. Procédé selon la revendication 10 ou 11, **caractérisé en ce qu'**une couche tampon est appliquée de manière épitactique sur le substrat métallique, qui croît cristallographiquement selon un agencement tourné par rapport au substrat métallique sur celui-ci.

13. Substrat métallique à texturation biaxiale ou agencement stratifié fabriqué par un procédé selon l'une quelconque des revendications 1 à 12.
